# EUROPEAN PATENT APPLICATION

(11) **EP 4 550 979 A1**
(43) Date of publication of application: **07.05.2025**
(21) Application number: 24315475.4
(22) Date of filing: 16.10.2024
(51) Int. Cl.: H10D 84/05, H10D 30/47, H10D 62/17, H10D 62/85, H10D 84/82

(54) **NORMALLY-ON GAN HEMT INTEGRATION ON MONOLITHIC P-GAN INTEGRATED CIRCUITS**

(30) Priority: 30.10.2023 US 202318385137
(71) Applicant: STMicroelectronics International N.V., 1228 Plan-les-Ouates, Geneva (CH)
(72) Inventor: Giorgino, Giovanni, 95041 CALTAGIRONE (CT) (IT); Castagna, Maria Eloisa, 95123 CATANIA (IT); Guillon, Virgil, 37100 TOURS (FR); Tringali, Cristina, 96011 AUGUSTA (SR) (IT); Iucolano, Ferdinando, 95030 GRAVINA DI CATANIA (CT) (IT); Constant, Aurore, 37100 TOURS (FR)
(74) Representative: Studio Torta S.p.A.

(57) **Abstract**

Methods, systems, and apparatuses for normally-on GaN high electron mobility transistors (HEMT) integration on monolithic p-GaN integrated circuits (ICs) platforms are provided. In particular, the integrated circuit platforms may include both enhancement mode and depletion mode HEMT power devices in monolithically integrated p-GaN power ICs. Exemplary methods may include treating at least one of a plurality of p-GaN gates with an in-situ plasma treatment to deactivate Mg in the p-GaN gate treated and deplete this p-Gan gate of Mg. The depleted p-GaN gate is the gate for the normally on HEMT in the IC. At least one of the p-GaN gates not exposed to the in-situ plasma pretreatment is the gate of the normally off HEMT in the IC.

## Description

### TECHNOLOGICAL FIELD

Example embodiments of the present disclosure relate generally to high electron mobility transistors (HEMT), including normally-on gallium nitride (GaN) HEMT integration on monolithic p-GaN integrated circuits.

### BACKGROUND

GaN is normally on technology. Ap-GaN gate is used to achieve a normally off power device. GaN HEMT are normally depletion mode transistors, which is referred to as normally-on HEMTs. However, for some applications an integrated circuit (IC) including an enhancement mode transistor, sometimes referred to as normally-off, is needed for safe operation and circuit simplification. ICs may use GaN with p-doping to form p-GaN gates for the normally-off HEMT (though it is not necessary to have an undoped p-GaN as the p-GaN may also be etched), the normally-on HEMT on the same platform is obtained by etching the p-GaN. However, preparing an IC with both a normally-on HEMT and normally-off HEMT can involve many operations, including needing p-GaN etching to define a gate structure. This p-GaN etching may increase sheet resistance (RsH) of the finished power device.

The inventors have identified numerous areas of improvement in the existing technologies and processes, which are the subjects of embodiments described herein. Through applied effort, ingenuity, and innovation, many of these deficiencies, challenges, and problems have been solved by developing solutions that are included in embodiments of the present disclosure, some examples of which are described in detail herein.

### BRIEF SUMMARY

The present invention relates to a method for manufacturing an integrated circuit platform and to an integrated circuit platform, as defined in the annexed claims.

Various embodiments described herein relate to high electron mobility transistors (HEMT), including normally-on gallium nitride (GaN) HEMT integration on monolithic normally-off p-GaN integrated circuits.

In accordance with some embodiments of the present disclosure, an example method for manufacturing an integrated circuit platform is provided. The method for manufacturing an integrated circuit platform may comprise: providing a wafer comprising a AlGaN layer with a first surface and a p-GaN layer on the first of the AlGaN layer; etching the p-GaN layer to form at least a first p-GaN gate and a second p-GaN gate; depositing a first silicon based dielectric layer over the first p-GaN gate, the second p-GaN gate, and the AlGaN layer; etching the first silicon based dielectric layer to expose the second p-GaN gate and a first portion of the AlGaN layer; treating the second p-GaN gate and the first portion of the AlGaN layer with an in-situ plasma treatment, wherein the in-situ plasma treatment deactivates magnesium in the second p-GaN gate to form a depleted p-GaN gate; and forming at least a first normally-off HEMT and at least a first normally-on HEMT, wherein the gate of the normally-off HEMT is the first p-GaN gate, and wherein the gate of the normally-on HEMT is the depleted p-GaN gate.

In some embodiments, forming the first normally-off HEMT comprises forming a plurality of alumina layers; and forming the first normally-on HEMT comprises a single alumina layer.

In some embodiments, the first silicon based dielectric layer has a thickness of 70nm.

In some embodiments, the in-situ plasma treatment is comprises diffusing hydrogen into the second p-GaN gate and the AlGaN layer.

In some embodiments, the in-situ plasma treatment deactivates magnesium in the first portion of the AlGaN layer.

In some embodiments, forming the first normally-off HEMT further comprises depositing metallization layers associated with the first normally-off HEMT gate, first normally-off HEMT source, and first normally-off HEMT drain; and forming the first normally-on HEMT further comprises depositing metallization layers associated with the first normally-on HEMT gate, first normally-on HEMT source, and first normally-on HEMT drain.

In some embodiments, forming the first normally-off HEMT further comprises depositing at least a first metal shielding layer; and forming the first normally-on HEMT further comprises depositing at least a second metal shielding layer.

In some embodiments, the depleted p-GaN gate of the first normally-on HEMT has a flat capacitance trend as voltage increases.

In some embodiments, the p-GaN gate of the first normally-off HEMT has a Schottky capacitance trend as voltage increases.

In some embodiments, providing the wafer further comprises providing a TiN layer covering the p-GaN layer; and the first p-GaN gate of the first normally-off HEMT is covered by a first portion of the TiN layer; and wherein the depleted p-GaN gate of the first normally-on HEMT is covered by a second TiN layer.

In accordance with some embodiments of the present disclosure, an example integrated circuit platform is provided. The integrated circuit platform comprises a normally-off HEMT and a normally on HEMT; wherein the normally-off HEMT is comprised of a p-doped GaN gate on an AlGaN layer; wherein the normally-on HEMT is comprised of a depleted p-GaN gate depleted with an in-situ plasma treatment on the AlGaN layer.

In some embodiments, the normally-off HEMT further comprises a plurality of alumina layers; and the normally-on HEMT further comprises a single alumina layer.

In some embodiments, the first silicon based dielectric layer has a thickness of 70nm.

In some embodiments, the depleted p-GaN gate comprises Mg-H formed from diffusing hydrogen into the second p-GaN gate.

In some embodiments, the first portion of the AlGaN exposed to the in-situ plasma treatment comprises deactivated magnesium.

In some embodiments, the normally-off HEMT further comprises metallization layers associated with the normally-off HEMT gate, normally-off HEMT source, and normally-off HEMT drain; and the normally-on HEMT further comprises metallization layers associated with the normally-on HEMT gate, normally-on HEMT source, and normally-on HEMT drain.

In some embodiments, the normally-off HEMT further comprises at least a first metal shielding layer; and the normally-on HEMT further comprises at least a second metal shielding layer.

In some embodiments, the depleted p-GaN gate of the normally-on HEMT has a flat capacitance trend as voltage increases.

In some embodiments, the p-GaN gate of the normally-off HEMT has a Schottky capacitance trend as voltage increases.

In some embodiments, the first p-GaN gate is covered by a first TiN layer; and wherein the depleted p-GaN gate is covered by a second TiN layer.

The above summary is provided merely for purposes of summarizing some example embodiments to provide a basic understanding of some aspects of the disclosure. Accordingly, it will be appreciated that the above-described embodiments are merely examples and should not be construed to narrow the scope or spirit of the disclosure in any way. It will also be appreciated that the scope of the disclosure encompasses many potential embodiments in addition to those here summarized, some of which will be further described below.

### BRIEF SUMMARY OF THE DRAWINGS

Having thus described certain example embodiments of the present disclosure in general terms, reference will now be made to the accompanying drawings, which are not necessarily drawn to scale, and wherein:
FIG. 1 illustrates a first cross-section view of a block diagram of a first exemplary power device in accordance with one or more embodiments of the present disclosure;
FIG. 2 illustrates an example flowchart of operations for manufacturing a power device in accordance with one or more embodiments of the present disclosure;
FIG. 3A-3F illustrate example block diagrams associated with operations for manufacturing a power device in accordance with one or more embodiments of the present disclosure;
FIG. 4 illustrates a first capacitance versus voltage graph associated with an undoped p-GaN gate;
FIG. 5 illustrates a first capacitance versus voltage graph associated with one or more embodiments of the present disclosure; and
FIG. 6A-6B illustrate current versus voltage graphs associated with one or more embodiments of the present disclosure.

### DETAILED DESCRIPTION

Some embodiments of the present disclosure will now be described more fully herein with reference to the accompanying drawings, in which some, but not all, embodiments of the disclosure are shown. Indeed, various embodiments of the disclosure is embodied in many different forms and should not be construed as limited to the embodiments set forth herein; rather, these embodiments are provided so that this disclosure will satisfy applicable legal requirements. Like reference numerals refer to like elements throughout.

As used herein, the term "comprising" means including but not limited to and should be interpreted in the manner it is typically used in the patent context. Use of broader terms such as comprises, includes, and having should be understood to provide support for narrower terms such as consisting of, consisting essentially of, and comprised substantially of.

The phrases "in various embodiments," "in one embodiment," "according to one embodiment," "in some embodiments," and the like generally mean that the particular feature, structure, or characteristic following the phrase is included in at least one embodiment of the present disclosure and is included in more than one embodiment of the present disclosure (importantly, such phrases do not necessarily refer to the same embodiment).

The word "example" or "exemplary" is used herein to mean "serving as an example, instance, or illustration." Any implementation described herein as "exemplary" is not necessarily to be construed as preferred or advantageous over other implementations.

If the specification states a component or feature "may," "can," "could," "should," "would," "preferably," "possibly," "typically," "optionally," "for example," "often," or "might" (or other such language) be included or have a characteristic, that a specific component or feature is not required to be included or to have the characteristic. Such a component or feature is optionally included in some embodiments or it is excluded.

### Overview

Various embodiments of the present disclosure are directed to integrating a normally-on GaN HEMT into a normally-off p-GaN. In particular, the present disclosure includes obtaining both enhancement mode (E-mode) and depletion mode (D-mode) HEMT power devices in monolithically integrated p-GaN power ICs.

For GaN HEMT devices, undoped GaN devices are normally on because of the GaN disposing the device to be a normally-on device. To achieve a normally off device, it is possible to dope a GaN layer with magnesium (Mg) to form a p-GaN layer. The p-doped gate allows for depletion of the electrons to have a normally off device. A normally off HEMT power device requires. a voltage to be applied to the gate to transition or switch the HEMT power device to an on state and conduct current.

A structure for ICs with GaN HEMTs includes a silicon substrate beneath a GaN buffer that is beneath an AlGaN layer. The AlGaN layer allows for conduction between the source and gate of the HEMT.

The conduction comes from an electron concentration under the AlGaN layer. When a voltage is applied to the drain then will have conduction between the gate and the drain.

Co-integration of depletion-mode (D-mode) HEMTs on a p-GaN-based GaN-on-Silicon integrated circuit (IC) platform enables the design of integrated circuits with greater functionality and increased performance. However, with using p-GaN the whole surface of AlGaN of D-mode HEMTs can be damaged due to p-GaN etching. Moreover, the gate metal for D-mode HEMTs is the same used for E-mode ones, thus limiting the tunability of the threshold voltage of the D-mode devices.

An advantage of the present disclosure is to integrate a D-mode structure in a monolithic IC to avoid p-GaN etching that can cause surface damage to the AlGaN layer and also an unstable voltage threshold (Vth). Embodiments of the present disclosure allow for Vth tailoring by varying certain operations described herein. Additionally or alternatively, the normally-on power devices can be manufactured along with the normally-off power devices on a single manufacturing line, which is distinct from conventional manner that require different manufacturing operations and different manufacturing lines.

The power devices of the present disclosure can be used in a myriad of applications. For example, various embodiments of the present disclosure is used in DC-DC convertor applications.

### Exemplary Methods, Systems, and Apparatuses

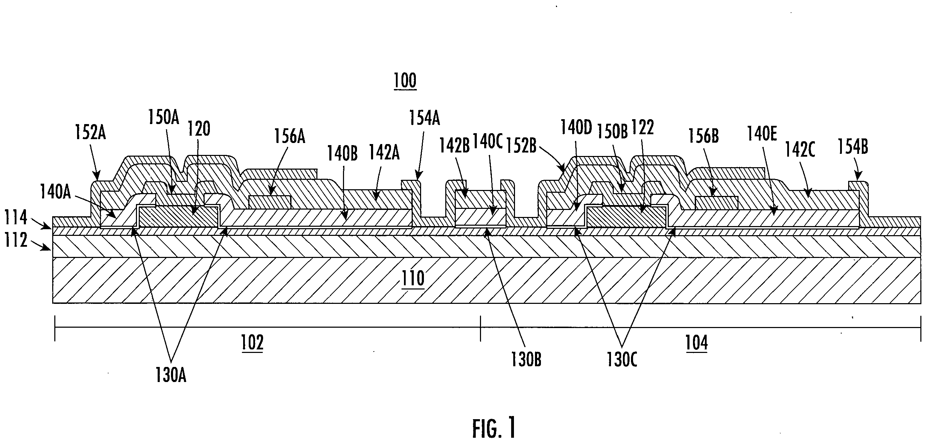

FIG. 1 illustrates a first cross-section view of a block diagram of a first exemplary power device in accordance with one or more embodiments of the present disclosure. The exemplary power device illustrated in FIG. 1 is after manufacturing operations of exemplary methods have been completed, which are described further herein.

As illustrated in FIG. 1, a power device 100 includes two p-GaN HEMTs. A normally-off p-GaN HEMT 102 is on the left portion of the figure and a normally-on depleted p-GaN HEMT 104 is on the right portion of the figure. The normally-off p-GaN HEMT 102 and the normally-on depleted p-GaN HEMT 104 isis on top of a silicon substrate layer 110 that is beneath a GaN layer 112, that is beneath an AlGaN layer 114. Above the AlGaN layer are a p-GaN gate 120 and a depleted p-GaN gate 122. The p-GaN layer is etched to form the p-GaN gate 120 and the depleted p-GaN gate 122. As described further herein, the depleted p-GaN gate 122 is treated with plasma to form the depleted p-GaN gate 122 from the associated portion of the p-GaN layer left after etching. The treatment with plasma is selective and depletes the p-GaN by depleting the Mg in this region through the diffusion of hydrogen into this region in the plasma treatment. The hydrogen also diffuses into the AlGaN layer 114 near the depleted p-GaN gate 122. The depleted p-GaN gate 122 as a part of the depleted p-GaN gate allows for the normally-off functionality.

The normally-off p-GaN HEMT 102 includes a gate, a source, and a drain. The metal contact of the gate of the normally-off p-GaN HEMT 102 is illustrated metallization layer 150A. The metal contact of the source of the normally-off p-GaN HEMT 102 is illustrated metallization layer 152A. The metal contact of the drain of the normally-off p-GaN HEMT 102 is illustrated metallization layer 154A. The normally-off p-GaN HEMT 102 also includes one or more other metal shielding(s) 156 (e.g., 156A) that are for controlling electrical fields generated when the power device is operated.

The normally-on depleted p-GaN HEMT 104 includes a gate, a source, and a drain. The metal contact of the gate of the normally-on depleted p-GaN HEMT 104 is illustrated as metallization layer 150B. The metal contact of the source of the normally-on depleted p-GaN HEMT 104 is illustrated as metallization layer 152B. The metal contact of the drain of the normally-on depleted p-GaN HEMT 104 is illustrated as metallization layer 154B. The normally-on depleted p-GaN HEMT 104 also includes one or more other metal shielding(s) 156 (e.g., 156B) that are for controlling electrical fields generated when the power device is operated.

The power devices also include a number of alumina (Al₂0₃) layers (e.g., 130A, 130B, 130C) and a number of silicon based dielectric (e.g., silicon oxide, silicon nitride, etc.) layers (e.g., 140A, 140B, 140C, 140D, 140E, 142A, 142B, 142C). In one embodiment, these alumina layers and silicon based dielectric layers isare deposited one layer at a time and are etched to allow for exposing one or more surfaces, such as to allow for further layers to be deposited in the one or more layer portions removed by etching.

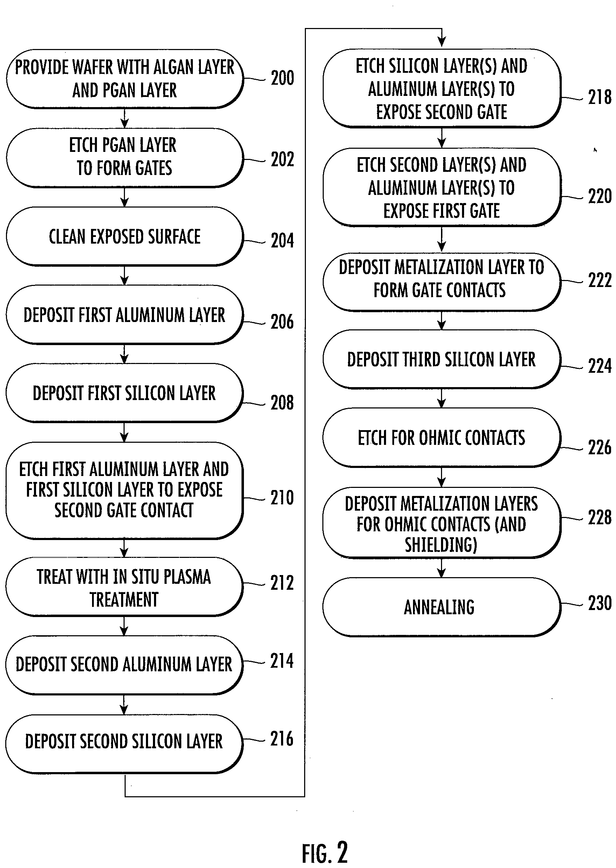

FIG. 2 illustrates an example flowchart of operations for manufacturing a power device in accordance with one or more embodiments of the present disclosure.

At operation 200, a wafer with an AlGaN layer covered by a p-GaN layer is provided. The wafer also includes a GaN layer 112 under the AlGaN 114 and a silicon substrate layer 110 is under the GaN layer 112. The p-GaN layer is used to form the p-GaN gate 120 and also the region that will become the depleted p-GaN gate 122.

At operation 202, p-GaN layer is etched to form gates. Multiple gates isare etched from the p-GaN layer. In various embodiments, a first gate is etched for the p-GaN gate 120 and a second gate is etched for what will be the depleted p-GaN gate 122. The P-GaN layer is etched in Cl₂/0₂. In various embodiments there is also a TiN layer over the p-GaN layer (e.g., a self-aligned gate approach). The TiN layer is etched with BCl3. In various embodiments, performing the etching includes TiN lateral recess by wet etch with SiN HM, resist strip in O₂/N₂ plasma, and polymer removal in EKC265.

At operation 204, an exposed surface is cleaned. This cleaning operation will clean the exposed surface of the AlGaN layer 114 and the first and second gates. In various embodiments, the cleaning utilizes hot HCl and/or HF.

At operation 206, a first alumina layer is deposited. A first alumina layer 130 is deposited over the AlGaN layer 114 and the first gate 120 and second gate 122A. In various embodiments, the alumina layer is for example Al₂O₃ to a thickness of 5nm and heated to 300°C via a thermal or a plasma process. The thickness is varied. Other examples include a thickness in the range 2.5nm to 7.5 nm.

At operation 208, a first silicon based dielectric layer is deposited. In various embodiments the first based dielectric silicon layer 140 is PECVD SiO₂ SiH4-based at thickness of 260nm.

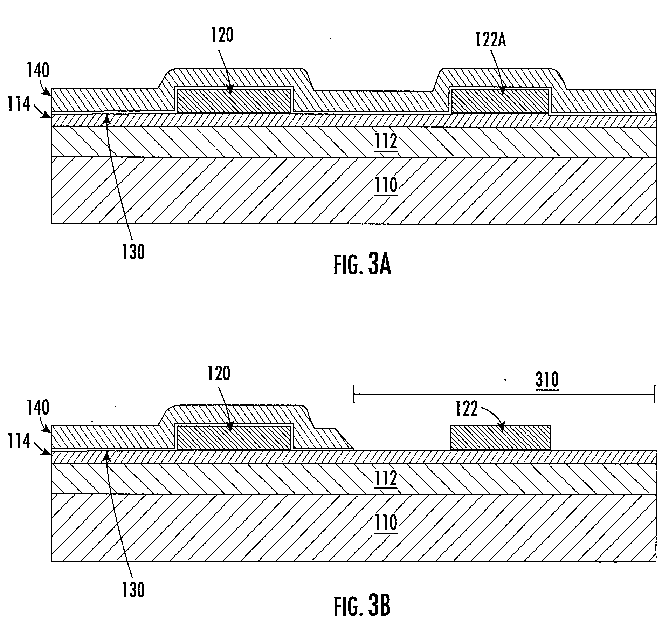

An illustration of the wafer after operation 208 is illustrated in FIG. 3A.

At operation 210, the first silicon based dielectric layer and the first alumina layer are etched to expose the second gate contact 122A. The etching of the first silicon based dielectric layer 140 and the first alumina layer 130 removes these layers over a first portion 310 of the wafer to expose the AlGaN layer 114 and the second gate 122A in this first portion 310. This etching utilizes CF₄ EP on the AlGaN layer 114, resist stripping with 0₂/N₂ plasma, and/or polymer removal in EKC265.

At operation 212, perform in situ-plasma treatment. The in situ-plasma treatment isis applied to the exposed first portion 310 of the AlGaN layer 114 and the second gate 122A. The in-situ plasma treatment utilizes a NH₃ plasma treatment. The in-situ plasma treatment accelerates Mg deactivation through introduction of hydrogen (H) that forms a Mg-H complex formation and this deactivates the Mg doping of the exposed p-GaN layer of the second gate 122A to form the depleted p-GaN gate 122, which reduces the sheet resistance (Rsh) of the AlGaN layer 114. The in-situ plasma treatment also deactivates some of the Mg in the AlGaN layer 114. The deactivation of the Mg in p-GaN achieves an intrinsic GaN layer.

In various embodiments, the in-situ plasma treatment is performed, for example, on a wafer in a direct plasma chamber with NH3/N2 flow and with a power range between 150 and 300W. Additionally or alternatively, a temperature in the range of 300°C accelerates Mg deactivation through introduction of hydrogen. By modifying the conditions of operation 212 to diffuse additional hydrogen and/or deactivate greater amounts of Mg then the Vth is further decreased.

An illustration of the wafer after operation 212 is illustrated in FIG. 3B.

At operation 214, deposit second alumina layer. A second alumina layer 132 (Al₂O₃) is deposited. For the first portion 310 of the wafer the second alumina layer 132 will cover the AlGaN layer 114 and the depleted p-GaN gate 122. Outside of the first portion 310 of the wafer the second alumina layer 132 is deposited on the first silicon based dielectric layer 140.

In various embodiments the second alumina layer 132 is of a different thickness than the prior alumina layer 130. This is a second alumina layer thickness of the second alumina layer 132 while the first alumina layer 130 has a first alumina layer thickness. The second alumina layer thickness is, for example, 3nm, 5nm, 7nm, or the like. A change in thickness of the second alumina layer 132 is associated with different gate leakages. Though the gate leakage will also depend on other aspects of the power device, including the profile of the p-GaN gate (e.g, 120). In various embodiments, the second alumina layer 132 isis an ALD Al₂O₃ deposition.

At operation 216, deposit second silicon based dielectric layer. The second silicon based dielectric layer 142 is deposited. The second silicon based dielectric layer 142 is used to seal the depleted p-GaN gate 122. In various embodiments the second silicon based dielectric layer is PECVD SiO₂ SiH₄-based at thickness of 70nm.

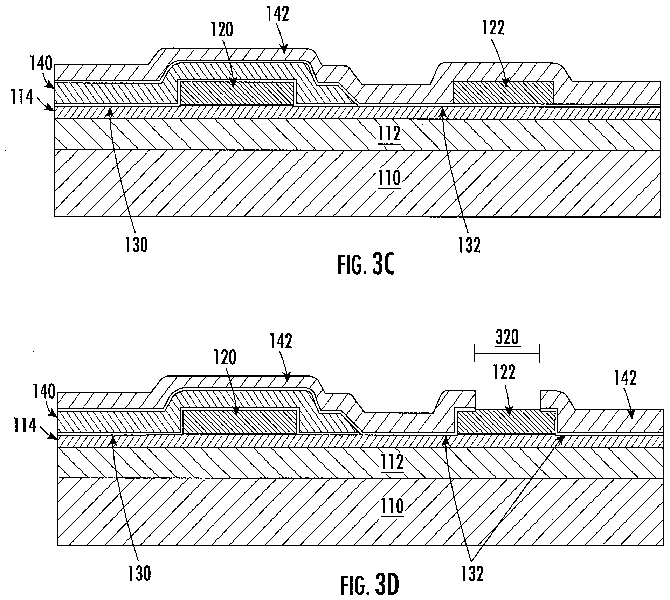

An illustration of the wafer after operation 216 is illustrated in FIG. 3C.

At operation 218, etch silicon based dielectric layer(s) and alumina layer(s) to expose second gate. The etching is at a second portion 320 of the wafer that is etched to remove the second silicon based dielectric layer 142 and the second alumina layer 132 to expose the depleted p-GaN gate 122. This etching utilizes CF₄ EP on the alumina layer 132, resist stripping with 0₂/N₂ plasma, and/or polymer removal in EKC265.

An illustration of the wafer after operation 218 is illustrated in FIG. 3D.

At operation 220, etch silicon based dielectric layer(s) and alumina layer(s) to expose first gate. The etching is at a third portion 330 of the wafer that is etched to remove the first and second silicon based dielectric layers 140, 142 and the first and second alumina layers 130, 132 to expose the p-GaN gate 120. This etching utilizes CF₄ EP, resist stripping with 0₂/N₂ plasma, polymer removal in EKC265, and/or pre-metal cleaning in HCl.

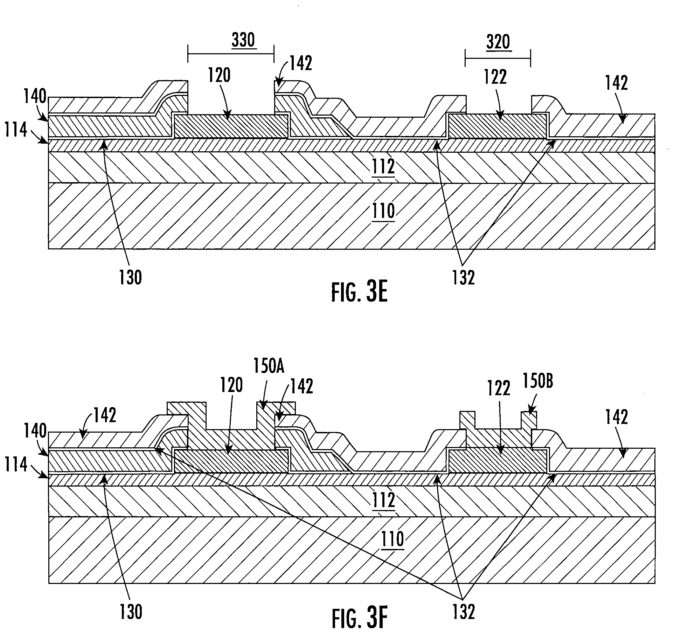

An illustration of the wafer after operation 220 is illustrated in FIG. 3E.

At operation 222, deposit metallization layer to form gate contacts. One or more metallization layers is deposited to form gate contact 150A for the p-GaN gate 120 and the gate contact 150B for the depleted p-GaN contact 122. This metallization layer deposition utilizes TiN/AlCu/TiN metallization and/or taper etching. The gate contacts 150A, 150B is self aligning.

An illustration of the wafer after operation 222 is illustrated in FIG. 3F.

At operation 224, deposit third silicon based dielectric layer. In various embodiments, a third based dielectric silicon layer 144 is deposited. In various embodiments the third silicon based dielectric layer is PECVD SiO2 SiH4-based.

At operation 226, etch for ohmic contacts. The etching for the ohmic contacts includes etching the silicon based dielectric layers and/or alumina layers to expose the AlGaN layer 114 for making the source contact 152 and drain contacts 154 of the power device. This etching may utilize CF4 EP on the AlGaN, BCl3 recess, resist stripping with 02/N2 plasma, polymer removal in EKC265, and/or pre-metal cleaning with HCl.

At operation 228, deposit metallization layer(s) for ohmic contacts (and shielding). This metallization layer is deposited to form the source contact 152A and drain contact 154A of the normally-off p-GaN HEMT 102 and the source contact 152B and drain contact 154B of the normally-on depleted p-GaN HEMT 104. In various embodiments, this metallization layer also includes one or more shielding metal portions deposited. This metallization layer deposition utilizes TiN/AlCu/TiN metallization and/or taper etching.

At operation 230, annealing is performed. The annealing is ohmic annealing. In various embodiments the ohmic annealing is performed at 560°C.

An illustration of the wafer after operation 230 is illustrated in FIG. 1.

In various embodiments, the operations after the in-situ plasma treatment is referred to as forming gates, sources, and drains of HEMTs as each of the operations goes to forming one or more structures needed for forming an HEMT power device 100.

It will be appreciated that the operations above is iterated, omitted, or varied. For example, various embodiments omit the deposition of one or more alumina layers.

FIG. 3A-3F illustrate example block diagrams associated with operations for manufacturing a power device in accordance with one or more embodiments of the present disclosure.

FIG. 3A illustrates a wafer after performance of operation 208.

FIG. 3B illustrates a wafer after performance of operation 212.

FIG. 3C illustrates a wafer after performance of operation 216.

FIG. 3D illustrates a wafer after performance of operation 218.

FIG. 3E illustrates a wafer after performance of operation 220.

FIG. 3F illustrates a wafer after performance of operation 222.

It will also be appreciated that various embodiments include for manufacturing of a normally-on depleted p-GaN HEMT power device by itself without one or more other power devices. Various embodiments include manufacturing a plurality of power devices on one wafer, such as a plurality of normally-off p-GaN HEMT power devices and a plurality of normally-on depleted p-GaN HEMT power devices.

In various embodiments, the in-situ plasma treatment is omitted and instead a wafer is provided with a first portion of doped p-GaN (e.g., a portion containing gate 120) and a second portion of undoped GaN (e.g., a portion containing gate 122). This may occur via one or more operations of growing a GaN layer that is undoped and then performing selective ion-implantation to selectively dope the first portion of this GaN layer with Mg while leaving the second portion of this GaN layer undoped. The undoped portion is later used for forming the normally-on HEMT.

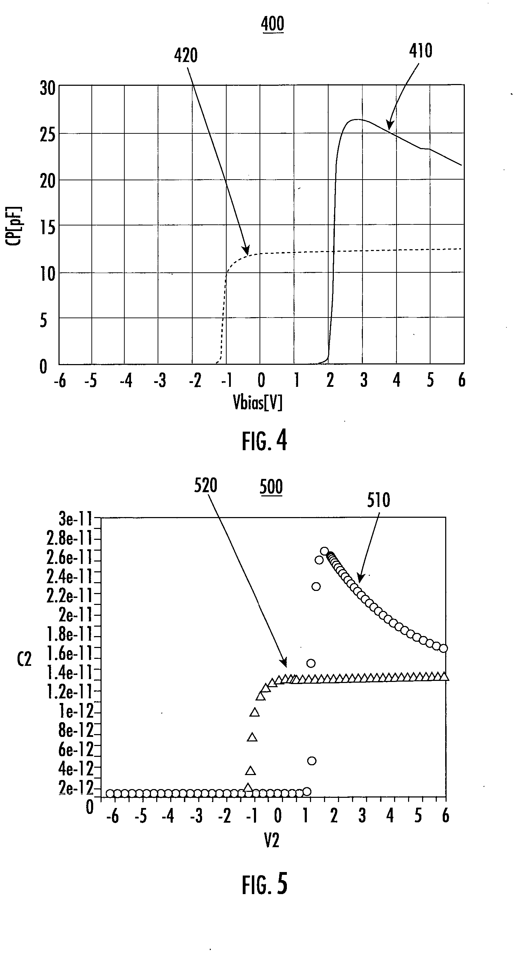

FIG. 4 illustrates a first capacitance versus voltage graph associated with a doped p-GaN gate and an undoped GaN gate. The doped p-GaN gate is used to form a normally-off HEMT power device as described herein. An undoped GaN gate is used to conventionally form a normally-on HEMT power device. A first curve 410 is a capacitance versus voltage curve for the p-GaN gate, which depicts a Schottky capacitance trend. The second curve 420 is associated with the undoped GaN gate, which depicts a flat capacitance curve.

In the Schottky capacitance trend, the trend begins with a positive voltage bias applied that has a large raise and then decreases as voltage increases. This trend depends on the p-GaN activation, which depends on the Mg concentration as well as the composition of the p-GaN and the AlGaN layers. In the undoped GaN gate of a normally on device that is normally-on at 0 volts. The undoped GaN has a flat capacitance as voltage increases.

FIG. 5 illustrates a first capacitance versus voltage graph associated with one or more embodiments of the present disclosure. FIG. 5 illustrates a first curve 510 associated with a doped p-GaN gate that is used to form a normally-off HEMT power device as described herein. The second curve 520 illustrated is associated with a depleted p-GaN gate for a normally-on HEMT power device. The second curve 520 depicts a flat capacitance curve.

As is seen from comparing curve 420 to curve 520, the depleted p-GaN gate of the present disclosure has the same flat capacitance curve as conventional undoped GaN gate.

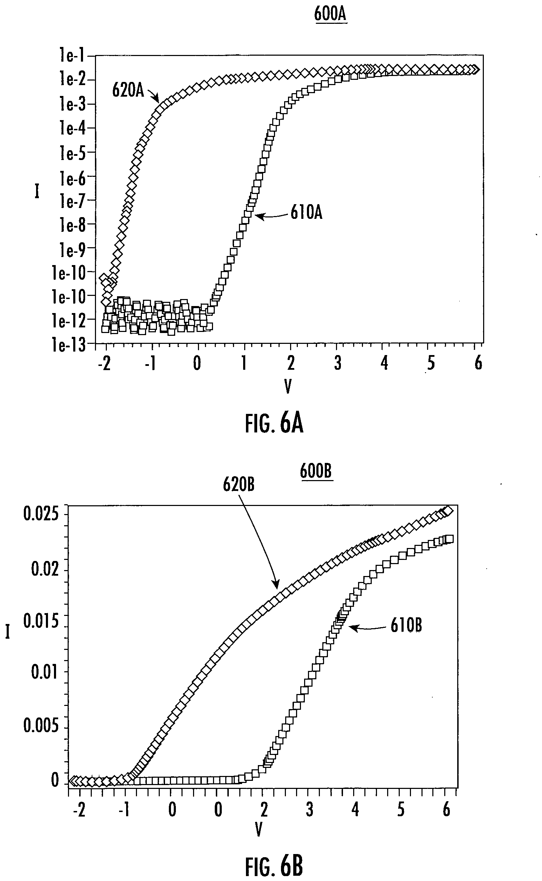

FIGS. 6A-6B illustrate current versus voltage graphs associated with one or more embodiments of the present disclosure. FIG. 6A uses a semilog scale for current on the y-axis and FIG. 6B uses a linear scale for current on the y-axis. The curves 610A, 610B are associated with a p-GaN gate. The curves 620A, 620B are associated with a depleted p-GaN gate. The in-situ plasma treatment allows for the voltage threshold to be decreased, which is illustrated as a negative shift from 610A to 620A and from 610B to 620B.

It should be readily appreciated that the embodiments of the methods, systems, and apparatuses described herein is configured in various additional and alternative manners in addition to those expressly described herein. In various embodiments this include adding or omitting one or more operations. It should also be readily appreciated that the illustrations of the figures herein as not drawn to scale and thus certain portions of a figure is different than illustrated.

### Conclusion

Operations and/or functions of the present disclosure have been described herein, such as in flowcharts. The flowchart blocks support combinations of means for performing the specified operations and/or functions and combinations of operations and/or functions for performing the specified operations and/or functions.

While this specification contains many specific embodiments and implementation details, these should not be construed as limitations on the scope of any disclosures or of what is claimed, but rather as descriptions of features specific to particular embodiments of particular disclosures. Certain features that are described herein in the context of separate embodiments can also be implemented in combination in a single embodiment. Conversely, various features that are described in the context of a single embodiment can also be implemented in multiple embodiments separately or in any suitable subcombination. Moreover, although features is described above as acting in certain combinations and even initially claimed as such, one or more features from a claimed combination can in some cases be excised from the combination, and the claimed combination is directed to a subcombination or variation of a subcombination.

While operations and/or functions are illustrated in the drawings in a particular order, this should not be understood as requiring that such operations and/or functions be performed in the particular order shown or in sequential order, or that all illustrated operations be performed, to achieve desirable results. In certain circumstances, operations and/or functions in alternative ordering is advantageous. In some cases, the actions recited in the claims is performed in a different order and still achieve desirable results. Thus, while particular embodiments of the subject matter have been described, other embodiments are within the scope of the following claims.

While this detailed description has set forth some embodiments of the present invention, the appended claims cover other embodiments of the present invention which differ from the described embodiments according to various modifications and improvements.

## Claims

1. A method for manufacturing an integrated circuit platform comprising:
providing (200) a wafer comprising a AlGaN layer with a first surface and a p-GaN layer on the first of the AlGaN layer;
etching (202) the p-GaN layer to form at least a first p-GaN gate and a second p-GaN gate;
depositing (208) a first silicon based dielectric layer over the first p-GaN gate, the second p-GaN gate, and the AlGaN layer;
etching (210) the first silicon based dielectric layer to expose the second p-GaN gate and a first portion of the AlGaN layer;
treating (212) the second p-GaN gate and the first portion of the AlGaN layer with an in-situ plasma treatment, wherein the in-situ plasma treatment deactivates magnesium in the second p-GaN gate to form a depleted p-GaN gate; and
forming at least a first normally-off HEMT and at least a first normally-on HEMT, wherein the gate of the first normally-off HEMT is the first p-GaN gate, and wherein a gate of the first normally-on HEMT is the depleted p-GaN gate.

2. The method of claim 1, wherein forming the first normally-off HEMT comprises forming (206, 214) a plurality of alumina layers; and
wherein forming the first normally-on HEMT comprises a single alumina layer.

3. The method of claim 1 or claim 2, wherein the first silicon based dielectric layer has a thickness of 70nm.

4. The method of anyone of the preceding claims, wherein the in-situ plasma treatment includes diffusing hydrogen into the second p-GaN gate and the AlGaN layer.

5. The method of anyone of the preceding claims, wherein the in-situ plasma treatment includes deactivating magnesium in the first portion of the AlGaN layer.

6. The method of anyone of the preceding claims, wherein forming the first normally-off HEMT further comprises depositing (222) metallization layers associated with a first normally-off HEMT gate, a first normally-off HEMT source, and a first normally-off HEMT drain; and
wherein forming the first normally-on HEMT further comprises depositing metallization layers associated with a first normally-on HEMT gate, a first normally-on HEMT source, and a first normally-on HEMT drain.

7. The method of claim 6, wherein forming the first normally-off HEMT further comprises depositing (228) at least a first metal shielding layer; and
wherein forming the first normally-on HEMT further comprises depositing at least a second metal shielding layer.

8. The method of anyone of the preceding claims, wherein the depleted p-GaN gate of the first normally-on HEMT is configured to have a flat capacitance trend as voltage increases;
alternatively:
wherein the p-GaN gate of the first normally-off HEMT is configured to have a Schottky capacitance trend as voltage increases.

9. The method of anyone of the preceding claims, wherein providing the wafer further comprises providing a TiN layer covering the p-GaN layer; and
wherein the first p-GaN gate of the first normally-off HEMT is covered by a first portion of the TiN layer; and wherein the depleted p-GaN gate of the first normally-on HEMT is covered by a second TiN layer.

10. An integrated circuit platform comprising:
a normally-off HEMT (102) and a normally-on HEMT (104);
wherein the normally-off HEMT comprises a p-doped GaN gate (120) on an AlGaN layer; and
wherein the normally-on HEMT comprises a depleted p-GaN gate (122) on the AlGaN layer.

11. The integrated circuit platform of claim 10, wherein the normally-off HEMT (102) further comprises a plurality of alumina layers (130, 132); and
wherein the normally-on HEMT (104) further comprises a single alumina layer.

12. The integrated circuit platform of claim 10 or claim 11, further comprising a silicon based dielectric layer (142), wherein the silicon based dielectric layer has a thickness of 70nm.

13. The integrated circuit platform of anyone of claims 10-12, wherein the depleted p-GaN gate comprises Mg-H formed from diffusing hydrogen into the depleted p-GaN gate.

14. The integrated circuit platform of anyone of claims 10-13, further comprising a first portion of the AlGaN layer, wherein the first portion of the AlGaN layer comprises deactivated magnesium from exposure to the in-situ plasma treatment.

15. The integrated circuit platform of anyone of claims 10-14, wherein the normally-off HEMT (102) further comprises metallization layers associated with a normally-off HEMT gate, a normally-off HEMT source, and a normally-off HEMT drain; and
wherein the normally-on HEMT (104) further comprises metallization layers associated with a normally-on HEMT gate, a normally-on HEMT source, and a normally-on HEMT drain.

16. The integrated circuit platform of anyone of claims 10-15, wherein the normally-off HEMT further comprises at least a first metal shielding layer (156A); and
wherein the normally-on HEMT further comprises at least a second metal shielding layer (156B).
